(19)

Europäisches
Patentamt

European
Patent Office

Office européen
des brevets

(11) **EP 4 530 009 A1**

(12) **EUROPEAN PATENT APPLICATION**
published in accordance with Art. 153(4) EPC

(43) Date of publication:
**02.04.2025  Bulletin 2025/14**

(21) Application number: **23940001.3**

(22) Date of filing: **10.08.2023**

(51) International Patent Classification (IPC):
**B23K 35/363** (2006.01)

(86) International application number:
**PCT/JP2023/029244**

(87) International publication number:
**WO 2025/032800 (13.02.2025 Gazette 2025/07)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koki Company Limited**
**Tokyo 120-0026 (JP)**

(72) Inventors:
• **OOTANI, Satoshi**
  **Tokyo 120-0026 (JP)**
• **SATO, Yuusuke**
  **Tokyo 120-0026 (JP)**
• **MURATA, Michiko**
  **Tokyo 120-0026 (JP)**

(74) Representative: **Stolmár & Partner**
**Patentanwälte PartG mbB**
**Blumenstraße 17**
**80331 München (DE)**

(54) **FLUX, SOLDER PASTE, AND METHOD FOR PRODUCING BONDED STRUCTURE**

(57)     A flux of the present invention is a flux used for soldering. The flux includes: at least one selected from the group consisting of a fatty alcohol having one hydroxy group and being solid at 20°C and a fatty acid ester being solid at 20°C; a liquid solvent having one or more and three or less hydroxy groups and being liquid at 20°C; and a solid solvent having two or more and four or less hydroxy groups and being solid at 20°C. The flux includes no thixotropic agent or includes 20.0 mass% or less of a thixotropic agent based on the entire flux.

EP 4 530 009 A1

**Description**

FIELD

The present invention relates to a flux, a solder paste, and a method for producing a joined structure.

BACKGROUND

For joining an electronic circuit substrate such as a printed wiring substrate and a joining part, a solder paste mixed with a solder alloy powder and a flux is used. The solder paste is applied to an electrode on a surface of the substrate and is heated (reflowed) with the electrode in contact with an electrode of the joining part. Thereby, the solder alloy powder is melted to form a solder joint portion, and a joined structure in which the substrate and the joining part are joined together via the solder joint portion can be obtained.

As the flux included in such a solder paste, a flux composed of a resin such as rosin, a solvent, a thixotropic agent, an activator, and the like is generally used. However, when soldering is performed using a solder paste including such a flux, a flux residue may remain around a soldered part. Therefore, an attempt has been made to reduce the flux residue by, for example, selecting the constituent components of the flux from highly volatile materials, or employing a decompression reflow or a decompression reduction reflow to sufficiently volatilize the flux in a reflow process.

For example, Patent Literature 1 discloses a flux that includes no resin such as rosin that is less prone to volatilize. An attempt has been made to reduce the flux residue for such a flux by using a liquid solvent and a solid solvent in combination instead of a resin such as rosin.

Conventionally, a solder foil is widely used for soldering in manufacturing power devices. However, in recent years, as an alternative material to the solder foil, a solder paste has attracted attention in the field of power device manufacturing. The solder paste makes it possible to collectively supply solder to a substrate by printing. Furthermore, in soldering using a solder paste, a jig for fixing parts to prevent misalignment and fall of parts during transportation of the substrate is not required. This makes it easier to automate the manufacturing process of joined structures, and therefore attempts are being actively made to apply the solder paste to soldering in the f power device manufacturing.

CITATION LIST

Patent Literature

Patent Literature 1: JP 2019-38026 A

However, the soldering reflow process has a problem that the reflow process time is long because it involves reduction of the flux residue after reflow. In particular, in the soldering of power devices, since the flux residue may cause defects in the post-process, reduction of the flux residue is further required. Therefore, in the soldering of power devices, the reflow process time tends to be longer.

SUMMARY

Technical Problem

The present invention has been made in view of the above circumstances, and it is an object to provide a flux, a solder paste, and a method for producing a joined structure that can shorten the reflow process time for realizing a low residue.

Solution to problem

A flux according to the present invention is a flux used for soldering, the flux including: at least one selected from the group consisting of a fatty alcohol having one hydroxy group and being solid at 20°C and a fatty acid ester being solid at 20°C; a liquid solvent having one or more and three or less hydroxy groups and being liquid at 20°C; and a solid solvent having two or more and four or less hydroxy groups and being solid at 20°C, the flux including no thixotropic agent or including 20.0 mass% or less of a thixotropic agent based on the entire flux.

A solder paste according to the present invention includes the flux and a solder alloy powder.

A method for manufacturing a joined structure according to the present invention includes joining a substrate and a joining part using a solder past.

DESCRIPTION OF EMBODIMENT

Hereinafter, a method for producing a flux, a solder paste, and a joined structure according to an embodiment of the present invention will be described.

<Flux>

A flux according to this embodiment includes at least one selected from the group consisting of a fatty alcohol and a fatty acid ester, a liquid solvent, and a solid solvent.

(Fatty Alcohol)

A fatty alcohol has one hydroxy group and is solid at 20°C. Examples of such a fatty alcohol include 1-tetradecanol, 1-hexadecanol, 1-octadecanol, 1-eicosanol, 1-docosanol, 1-dodecanol, and 1-tetracosanol. Among these, the fatty alcohol is preferably at least one selected from the group consisting of 1-tetradecanol, 1-hexadecanol, 1-octadecanol, 1-eicosanol, 1-docosanol, and the like.

The content of the fatty alcohol is preferably 0.5 mass% or more, more preferably 1.0 mass% or more, particularly preferably 5.0 mass% or more based on the entire flux. Further, the content of the fatty alcohol is preferably 45.0 mass% or less, more preferably 30.0 mass% or less, particularly preferably 20.0 mass% or less based on the entire flux. When two or more fatty alcohols are included, the content refers to the total content thereof.

(Fatty Acid Ester)

A fatty acid ester is solid at 20°C. Examples of such a fatty acid ester include methyl stearate, ethyl stearate, butyl stearate, methyl palmitate, ethyl palmitate, methyl arachidate, ethyl arachidate, methyl behenate, and the like. Among these, the fatty acid ester is preferably at least one selected from the group consisting of methyl stearate, ethyl stearate, and butyl stearate.

The content of the fatty acid ester is preferably 0.5 mass% or more, more preferably 1.0 mass% or more, particularly preferably 3.0 mass% or more based on the entire flux. Further, the content of the fatty acid ester is preferably 45.0 mass% or less, more preferably 20.0 mass% or less, particularly preferably 10.0 mass% or less based on the entire flux. When two or more fatty acid esters are included, the content refers to the total content thereof.

The flux according to this embodiment preferably includes both the fatty alcohol and the fatty acid ester from the viewpoint of suppressing the separation of the flux. The total content of the fatty alcohol and the fatty acid ester is preferably 1.0 mass% or more, more preferably 5.0 mass% or more, particularly preferably 10.0 mass% or more based on the entire flux. Further, the total content of the fatty alcohol and the fatty acid ester is preferably 45.0 mass% or less, more preferably 40.0 mass% or less, particularly preferably 30.0 mass% or less based on the entire flux.

(Liquid Solvent)

The flux according to this embodiment has one or more and three or less hydroxy groups and includes a liquid solvent being liquid at 20°C. Examples of such a liquid solvent include 3-methyl 1,5-pentanediol, 1,4-butanediol, 2,5-hexanediol, 1,5-pentanediol, 2,4-diethyl-1,5-pentanediol, 1,2,6-hexanetriol, 1,2,4-butanetriol, hexyldecanol, isostearyl alcohol, 2-octyldodecanol, 2-decyltetradodecanol, oleyl alcohol, 2-ethyl-1,3-hexanediol, 3-methyl-1,3-butanediol, glycerin, and the like.

At least one of the liquid solvents is preferably used from the viewpoint of increasing the volatility of the flux, and two or more of the liquid solvents are more preferably used from the viewpoint of increasing the viscosity stability of the solder paste. When at least one liquid solvent is used, it is preferably at least one selected from the group consisting of 3-methyl 1,5-pentanediol, 2,4-diethyl-1,5-pentanediol, 3-methyl-1,3-butanediol, 1,2,6-hexanetriol, and 1,2,4-butanetriol.

The content of the liquid solvent is preferably 5.0 mass% or more, more preferably 20.0 mass% or more based on the entire flux. Further, the content of the liquid solvent is preferably 80.0 mass% or less, more preferably 60.0 mass% or less based on the entire flux. When two or more of the liquid solvents are included, the content refers to the total content thereof.

(Solid Solvent)

The flux according to this embodiment includes a solid solvent having two or more and four or less hydroxy groups and being solid at 20°C. Examples of such a solid solvent include 2,2-dimethyl-1,3-propanediol, 2,5-dimethyl-2,5-hexanediol, 2,2,4-trimethyl-1,3-pentanediol, 2-butyl-2-ethyl-1,3-propanediol, 1,2-octanediol, 1,8-octanediol, 1,10-decanediol, 1,2-dodecanediol, 1,6-hexanediol, 1,9-nonanediol, trimethylolethane, trimethylolpropane, Erythritol, and the like. Among these, the solid solvent is preferably at least three selected from the group consisting of 2,2-dimethyl-1,3-propanediol, 2,5-dimethyl-2,5-hexanediol, 2,2,4-trimethyl-1,3-pentanediol, 2-butyl-2-ethyl-1,3-propanediol, 1,2-octanediol, 1,8-octanediol, 1,10-decanediol, 1,2-dodecanediol, 1,6-hexanediol, 1,9-nonanediol, trimethylolethane, trimethylolpropane, and erythritol from the viewpoint of improving the printability of the solder paste.

The content of the solid solvent is preferably 5.0 mass% or more, more preferably 25.0 mass% or more based on the entire flux. Further, the content of the solid solvent is preferably 92.0 mass% or less, more preferably 65.0 mass% or less based on the entire flux. When two or more of the solid solvents are included, the content refers to the total content thereof.

(Thixotropic Agent)

The flux according to this embodiment includes no thixotropic agent or includes 20.0 mass% or less of a thixotropic agent based on the entire flux. Examples of the thixotropic agent include a hydrogenated castor oil, a fatty acid amide, a fatty acid bisamide, a polyamide compound, a kaolin, a colloidal silica, an organic bentonite, and a glass frit. Among these, the thixotropic agent is preferably a fatty acid amide from the viewpoint of reducing the flux residue, and is more preferably a fatty acid amide. Examples of the fatty acid amide include stearate amide, laurate amide, palmitate amide, oleic acid amide, erucic acid amide, behenic acid amide, hydroxystearate amide, myristic acid amide, and the like. Among these, the fatty acid amide is preferably stearate amide, lauric acid amide, palmitic acid amide, oleic acid amide, erucic acid amide, or behenate amide. In addition, the thixotropic agents can be used alone or in combination with each other.

From the viewpoint of increasing the volatility of the flux, the content of the thixotropic agent is 20.0 mass% or less, preferably 15.0 mass% or less, more preferably 10.0 mass% or less based on the entire flux. Further, the flux according to this embodiment preferably includes no thixotropic agent from the viewpoint of increasing the volatility of the flux. When two or more thixotropic agents are included, the content refers to the total content thereof.

(Activator)

The flux according to this embodiment can include an activator. The activator is not particularly limited, and examples thereof include an organic acid-based activator, an amine-based compound, an amino acid, a halogen-based activator such as an amine halogen salt or a halogen compound, and the like. In addition, the activators can be used alone or in combination with each other.

The organic acid-based activator is not particularly limited, and examples thereof include a monocarboxylic acid such as a formic acid, an acetic acid, a propionic acid, a butyric acid, a valeric acid, a caproic acid, an enanthic acid, a capric acid, a laurylic acid, a myristic acid, a pentadecylic acid, a palmitic acid, a margaric acid, a stearic acid, a tubercross tearic acid, an arachidic acid, a behenic acid, a lignoceric acid, or a glycolic acid; a dicarboxylic acid such as an oxalic acid, a malonic acid, a succinic acid, a methylsuccinic acid, a glutaric acid, an adipic acid, a pimeline acid, a suberic acid, an azelaic acid, a sebasic acid, a fumaric acid, a maleic acid, a tartaric acid, or a diglycolic acid; other organic acids such as a dimer acid, a levulinic acid, a lactic acid, an acrylic acid, a benzoic acid, a salicylic acid, an anisic acid, a citric acid, or a picolinic acid.

The amine-based compound is not particularly limited, and examples thereof include an imidazole compound and a triazole compound. Examples of the imidazole compound include benzimidazole, 2-methylimidazole, 2-ethylimidazole, 2-ethyl-4-methylimidazole (2E4MZ), 2-heptadecylimidazole, 2-undecylimidazole, 1- (4,6-diamino-s-triazin-2-yl) ethyl-2-undecylimidazole, 1-butylimidazole, 2-phenylimidazole, 4-methyl-2-phenylimidazole, and the like. Examples of the triazole compound include benzotriazole, 1H-benzotriazole-1-methanol, 1-methyl-1H-benzotriazole, and the like. Examples of the other amine-based compounds include cetylamine, 3-(dimethylamino)-1,2-propanediol, 3,5-dimethylpyrazole, dimethylurea, hexahydro-1,3,5-triphenyl-1,3,5-triazine, pyrazinamide, N-phenylglycine, 3-methyl-5-pyrazolone, N-lauroyl sarcosine, 1,3-diphenylguanidine, and the like.

The amino acid is not particularly limited, and examples thereof include N-acetylphenylalanine (N-acetyl-L-phenylalanine, N-acetyl-DL-phenylalanine, N-acetyl-D-phenylalanine), N-acetylglutamic acid (N-acetyl-L-glutamic acid), N-acetylglycine, N-acetylleucine (N-acetyl-L-leucine, N-acetyl-DL-leucine, N-acetyl-D-leucine), N-acetylphenylglycine (N-acetyl-N-phenylglycine, N-acetyl-L-phenylglycine, N-acetyl-DL-phenylglycine), and the like.

The halogenated activator is not particularly limited, and examples thereof include an amine halogen salt, and a halogen compound. Examples of the amine of the amine halogen salt include diethylamine, dibutylamine, tributylamine, diphenylguanidine, cyclohexylamine, and the like. Example of the halogen of the amine halogen salt include fluorine, chlorine, bromine, and iodine. Examples of the halogen compound include tris(2,3-dibromopropyl) isocyanurate, 2,3-dibromo-2-butene-1,4-diol, 2-bromo-3-iodo-2-butene-1,4-diol, TBA-bis (2,3-dibromopropyl ether), 4,4'-diiodobiphenyl, and the like

The content of the activator is preferably 0.5 mass% or more, more preferably 1.0 mass% or more based on the entire flux. Further, the content of the activator is preferably 5.0 mass% or less, more preferably 3.0 mass% or less based on the entire flux. When two or more activators are included, the content refers to the total content thereof.

The flux according to this embodiment can include, as another additive, at least one selected from a stabilizer, a surfactant, a defoamer, and a corrosion inhibitor. The total content of other additives is not particularly limited, and can be, for example, 5.0 mass% or less based on the entire flux.

The flux according to this embodiment includes at least one selected from the group consisting of a fatty alcohol having one hydroxy group and being solid at 20°C and a fatty acid ester being solid at 20°C, the flux including no thixotropic agent or including 20.0 mass% or less of a thixotropic agent based on the entire flux. Thereby, the reflow process time to achieve low residue can be shortened.

According to the flux of this embodiment, it is preferable that the flux include the fatty alcohol, and the content of the fatty alcohol be 0.5 mass% or more and 45.0 mass% or less based on the entire flux. Thereby, the reflow process time to achieve low residue can be further shortened. In addition, the viscosity of the flux is increased, and hence the viscosity of the solder paste can be ensured.

According to the flux of this embodiment, it is preferable that the flux include the fatty acid ester, and the content of the fatty acid ester be 0.5 mass% or more and 45.0 mass% or less based on the entire flux. Thereby, the reflow process time to achieve low residue can be further shortened. In addition, the viscosity of the flux is increased, and hence the viscosity of the solder paste can be ensured.

According to the flux of this embodiment, the fatty alcohol is preferably at least one selected from the group consisting of 1-dodecanol, 1-tetradecanol, 1-hexadecanol, 1-octadecanol, 1-eicosanol, and 1-docosanol. Thereby, the reflow process time to achieve low residue can be further shortened.

According to the flux of this embodiment, the fatty acid ester is preferably at least one selected from the group consisting of methyl stearate, ethyl stearate, and butyl stearate. Thereby, the reflow process time to achieve low residue can be further shortened.

<Solder Paste>

The solder paste of this embodiment includes the above-described flux and a solder alloy powder. Examples of a solder alloy in the solder alloy powder include a lead-free solder alloy and an eutectic solder alloy including lead, but from the viewpoint of reducing environmental loads, it is preferably a lead-free solder alloy. Examples of the lead-free solder alloy include an alloy including tin, silver, copper, indium, zinc, bismuth, antimony, or the like. More specifically, examples thereof include alloys of Sn/Ag, Sn/Ag/Cu, Sn/Cu, Sn/Ag/Bi, Sn/Bi, Sn/Ag/Cu/Bi, Sn/Sb, Sn/Zn/Bi, Sn/Zn, Sn/Zn/Al, Sn/Ag/Bi/In, Sn/Ag/Cu/Sb, Sn/Ag/Sb, Sn/Ag/Cu/Bi , Sn/Ag/Cu/Bi/In/Sb, In/Ag, Sn/In, and the like. The alloy also includes an unavoidable impurity. The unavoidable impurity means a component that is inevitably mixed in the manufacturing process and is permissible to the extent that it does not affect the effect of the present invention.

The content of the flux is preferably 5 mass% or more and 20 mass% or less based on the entire solder paste. Further, the content of the solder alloy powder is preferably 80 mass% or more and 95 mass% or less based on the entire solder paste.

The solder paste according to this embodiment includes the flux and the solder alloy powder. Thereby, the reflow process time to achieve low residue can be shortened.

<Method for Producing Joined Structure>

According to a method for producing a joined structure of this embodiment, a substrate and a joining part are joined together using the solder paste. Specifically, in a reflow furnace, the substrate and the joining part are heated while being in contact with each other via the solder paste, and the solder alloy forming the solder paste is melted. Thereafter, the substrate and the joining part are joined together by cooling.

First, the solder paste is disposed on a surface of the substrate. The solder paste can be disposed using a known method such as printing with a solder printing apparatus, transfer printing, application with a dispenser, or mounting with a mounter. When the solder paste is printed using the solder printing apparatus, the thickness of the solder paste to be applied can be 30 $\mu$m or more and 600 $\mu$m or less. Further, the substrate is not particularly limited, and for example, a known substrate such as a printed substrate, a DBC substrate, a base plate substrate, a lead frame, or a silicon wafer can be used.

Next, the joining part is disposed so as to come into contact with the substrate via the solder paste. The joining part is not particularly limited, and for example, a chip component (an IC chip, etc.), a resistor, a diode, a capacitor, a transistor, a semiconductor chip (an Si chip, etc.), or a heat sink can be used.

Subsequently, the substrate and the joining part are heated in a state where they are in contact with each other via the solder paste. The heating temperature is not particularly limited, and can be appropriately selected according to the solder paste, and is in the range of the melting point of the solder paste or higher. The heating step can be performed in an inert gas atmosphere using nitrogen gas or the like for the purpose of suppressing oxidation of the metal. Further, the method can be performed under reduced-pressure atmosphere or vacuum atmosphere using a vacuum pump for the purpose of enhancing the release of gas. Further, a preheating step can be performed prior to the heating step. The preheating temperature is not particularly limited, can be appropriately selected according to the solder paste, and can be in the range below the melting point of the solder paste. The preheating step can be performed under reduced pressure or vacuum in inert gas atmosphere, or can be performed under reducing atmosphere using hydrogen gas or formic acid gas.

Finally, the substrate and the joining part in contact with each other via the solder paste are cooled. In the cooling step, for example, the temperature lowering rate is 120°C / min or more and 5°C / min or less, and cooling to 20 or higher and 200°C or lower is performed.

The method for producing the joined structure according to this embodiment uses the solder paste to join the substrate and the joining part. Thereby, the reflow process time to achieve low residue can be shortened.

The present invention includes the following aspects.

[1] A flux used for soldering,

the flux including: at least one selected from the group consisting of a fatty alcohol having one hydroxy group and being solid at 20°C and a fatty acid ester being liquid at 20°C;
a liquid solvent having one or more and three or less hydroxy groups and being solid at 20°C; and
a solid solvent having two or more and four or less hydroxy groups and being solid at 20°C,
the flux including no thixotropic agent or including 20.0 mass% or less of a thixotropic agent based on the entire flux.

[2] The flux including the fatty alcohol,
in which the content of the fatty alcohol is 0.5 mass% or more and 45.0 mass% or less based on the entire flux.
[3] The flux including the fatty acid ester,
in which the content of the fatty acid ester is 0.5 mass% or more and 45.0 mass% or less based on the entire flux.
[4] The flux according to any one of the above [1] to [3], in which the fatty alcohol is at least one selected from the group consisting of 1-dodecanol, 1-tetradecanol, 1-hexadecanol, 1-octadecanol, 1-eicosanol, and 1-docosanol.
[5] The flux according to any one of [1] to [4], in which the fatty acid ester is at least one selected from the group consisting of methyl stearate, ethyl stearate, and butyl stearate.
[6] A solder paste including the flux according to any one of [1] to [5], and a solder alloy powder.
[7] A method for producing a joined structure, in which a substrate and a joining part are joined together using the solder paste according to [6].

The flux, the solder paste, and the method for producing the joined structure according to the present invention are not limited to the above embodiments, and various modifications can be made without departing from the gist of the present invention. Further, the flux, the solder paste, and the method for producing the joined structure are not limited by the effect of the above-described embodiments. That is, it should be considered that the embodiments disclosed herein are merely examples in all respects and they are not restrictive. The scope of the present invention is defined by the appended claims rather than by the above description. In addition, the scope of the present invention is intended to include meanings equivalent to the claims and all changes without departing from the claims.

Examples

Hereinafter, examples of the present invention will be described, but the present invention is not limited to the following examples.

Material of Flux

(Fatty alcohol)

1-Tetradecanol: Manufactured by Tokyo Chemical Industry Co., Ltd.
1-Hexadecanol: Manufactured by Tokyo Chemical Industry Co., Ltd.
1-Octadecanol: Manufactured by Tokyo Chemical Industry Co., Ltd.
1-Eicosanol: Manufactured by Tokyo Chemical Industry Co., Ltd.

1-Docosanol: Manufactured by Tokyo Chemical Industry Co., Ltd.

(Fatty Acid Ester)

Methyl stearate: Manufactured by Tokyo Chemical Industry Co., Ltd.
Ethyl stearate: Manufactured by Tokyo Chemical Industry Co., Ltd.
Butyl stearate: Manufactured by Tokyo Chemical Industry Co., Ltd.

(Liquid Solvent)

3-methyl 1,5-pentanediol : Manufactured by Kuraray Co., Ltd.
1,4-butanediol: Manufactured by Tokyo Chemical Industry Co., Ltd.
2,5-hexanediol: Manufactured by Tokyo Chemical Industry Co., Ltd.
1,5-pentanediol: Manufactured by Tokyo Chemical Industry Co., Ltd.
2,4-diethyl-1,5-pentanediol: Manufactured by Tokyo Chemical Industry Co., Ltd.
1,2,6-hexanetriol: Manufactured by Tokyo Chemical Industry Co., Ltd.
1,2,4-butanetriol: Manufactured by Tokyo Chemical Industry Co., Ltd.
Hexyldecanol: Manufactured by Kokyu Alcohol Kogyo Co., Ltd.
Isostearyl alcohol: Manufactured by Kokyu Alcohol Kogyo Co., Ltd.
2-Octyldodecanol: Manufactured by Kokyu Alcohol Kogyo Co., Ltd.
2-Decyltetradodecanol: Manufactured by Kokyu Alcohol Kogyo Co., Ltd.
Oleyl alcohol: Manufactured by Kokyu Alcohol Kogyo Co., Ltd.

(Solid Solvent)

2,2-dimethyl-1,3-propanediol: Manufactured by Mitsubishi Gas Chemical Co., Ltd.
2,5-dimethyl-2,5-hexanediol: Manufactured by Tokyo Chemical Industry Co., Ltd.
2,2,4-trimethyl-1,3-pentanediol: Manufactured by Tokyo Chemical Industry Co., Ltd.
2-butyl-2-ethyl-1,3-propanediol: Manufactured by Tokyo Chemical Industry Co., Ltd.
1,2-octanediol: Manufactured by Tokyo Chemical Industry Co., Ltd.
1,8-octanediol: Manufactured by Tokyo Chemical Industry Co., Ltd.
1,10-decanediol: Manufactured by Tokyo Chemical Industry Co., Ltd.
1,2-dodecanediol: Manufactured by Tokyo Chemical Industry Co., Ltd.
1,6-hexanediol: Manufactured by Tokyo Chemical Industry Co., Ltd.
1,9-nonanediol: Manufactured by Tokyo Chemical Industry Co., Ltd.
Trimethylolethane: Manufactured by Mitsubishi Gas Chemical Co., Ltd.
Trimethylolpropane: Manufactured by Mitsubishi Gas Chemical Co., Ltd.
Erythritol: Manufactured by Tokyo Chemical Industry Co., Ltd.

(Thixotropic Agent)

Stearate amide: Manufactured by Kao Corporation
Lauric acid amide: Manufactured by Mitsubishi Chemical Corporation
Palmitate amide: Manufactured by Mitsubishi Chemical Corporation
Oleic acid amide: Manufactured by Kao Corporation
Erucamide: Manufactured by Nippon Fine Chemical Co., Ltd.
Behenic acid amide: Manufactured by Nippon Fine Chemical Co., Ltd.

Preparation of Flux

The materials of the flux were put into a heating container with the formulation shown in Table 1 to Table 10, and heated to 120°C so that all the materials were melted. Thereafter, by cooling to room temperature, a flux of each of examples, and a flux of each of comparative examples, in which the materials are uniformly dispersed were obtained. The mixing amounts shown in Table 1 to Table 10 each are equal to the content of each component included in the flux.

Preparation of Solder Paste

A flux of each example and each comparative example was mixed with the solder alloy powder (96.5 Sn / 3 Ag / 0.5 Cu, Type 3, manufactured by Koki Co., Ltd.) to have a flux of 9 mass%, and a solder alloy powder of 91 mass% so that the solder paste of each example and each comparative example was obtained.

[Table 1]

| CONTENT (MASS%) | | | EX. 1 | EX. 2 | EX. 3 | EX. 4 | EX. 5 | EX. 6 | EX. 7 | EX. 8 | EX. 9 | EX. 10 | EX. 11 | EX. 12 |
|---|---|---|---|---|---|---|---|---|---|---|---|---|---|---|
| | FATTY ALCOHOL | 1-Tetradecanol | 15 | - | - | - | - | - | - | - | 6 | - | - | - |
| | | 1-Hexadecanol | - | 15 | - | - | - | - | - | - | - | 6 | - | - |
| | | 1-Octadecanol | - | - | 15 | - | - | 12 | 12 | 12 | 6 | 6 | 6 | 6 |
| | | 1-Eicosanol | - | - | - | 15 | - | - | - | - | - | - | 6 | - |
| | | 1-Docosanol | - | - | - | - | 15 | - | - | - | - | - | - | 6 |
| | FATTY ACID ESTER | Methyl stearate | - | - | - | - | - | 3 | - | - | 3 | 3 | 3 | 3 |
| | | Ethyl stearate | - | - | - | - | - | - | 3 | - | - | - | - | - |
| | | Butyl stearate | - | - | - | - | - | - | - | 3 | - | - | - | - |
| | LIQUID SOLVENT | 3-methyl 1,5-pentanediol | 40 | 40 | 40 | 40 | 40 | 40 | 40 | 40 | 40 | 40 | 40 | 40 |
| | SOLID SOLVENT | 2,2-dimethyl-1,3-propanediol | 20 | 20 | 20 | 20 | 20 | 20 | 20 | 20 | 20 | 20 | 20 | 20 |
| | | 2,5-dimethyl-2,5-hexanediol | 20 | 20 | 20 | 20 | 20 | 20 | 20 | 20 | 20 | 20 | 20 | 20 |
| | | Trimethylolpropane | 5 | 5 | 5 | 5 | 5 | 5 | 5 | 5 | 5 | 5 | 5 | 5 |
| FLUX VOLATILITY | | Volatilization time [sec] | 132 | 161 | 154 | 227 | 240 | 165 | 211 | 218 | 148 | 162 | 240 | 240 |
| | | Volatilization amount of flux (%) | 100.0 | 100.0 | 99.9 | 97.2 | 97.4 | 99.8 | 99.7 | 99.9 | 99.6 | 100.0 | 99.5 | 97.6 |
| | | Evaluation ◎ / ○ / × | ◎ | ◎ | ◎ | ○ | ○ | ◎ | ○ | ○ | ◎ | ◎ | ○ | ○ |
| EVALUATION OF SOLDER PASTE A/B/C | | | B | A | A | A | A | A | A | A | A | A | A | A |

[Table 2]

| CONTENT (MASS%) | | | EX. 13 | EX. 14 | EX. 15 | EX. 16 | EX. 17 | EX. 18 | EX. 19 | EX. 20 | EX. 21 | EX. 22 | EX. 23 | EX. 24 | EX. 25 | EX. 26 | EX. 27 |
|---|---|---|---|---|---|---|---|---|---|---|---|---|---|---|---|---|---|
| | FATTY ALCOHOL | 1-Tetradecanol | - | - | - | - | - | - | - | - | - | - | - | - | - | - | - |
| | | 1-Hexadecanol | 1 | 3 | 5 | 10 | 15 | 20 | 30 | 35 | 40 | - | - | - | - | - | - |
| | | 1-Octadecanol | - | - | - | - | - | - | - | - | - | - | - | - | - | - | - |
| | | 1-Eicosanol | - | - | - | - | - | - | - | - | - | - | - | - | - | - | - |
| | | 1-Docosanol | - | - | - | - | - | - | - | - | - | 1 | 5 | - | - | - | 0.5 |
| | FATTY ACID ESTER | Methyl stearate | - | - | - | - | - | - | - | - | - | - | - | 3 | 5 | 10 | 0.5 |
| | LIQUID SOLVENT | 3-methyl 1,5-pentanediol | 47 | 46 | 45 | 42.5 | 40 | 37.5 | 32.5 | 30 | 27.5 | 47 | 45 | 46 | 45 | 42.5 | 47 |
| | SOLID SOLVENT | 2,2-dimethyl-1,3-propanediol | 23.5 | 23 | 22.5 | 21.25 | 20 | 18.75 | 16.25 | 15 | 13.75 | 23.5 | 22.5 | 23 | 22.5 | 21.25 | 23.5 |
| | | 2,5-dimethyl-2,5-hexanediol | 23.5 | 23 | 22.5 | 21.25 | 20 | 18.75 | 16.25 | 15 | 13.75 | 23.5 | 22.5 | 23 | 22.5 | 21.25 | 23.5 |
| | | Trimethylolpropane | 5 | 5 | 5 | 5 | 5 | 5 | 5 | 5 | 5 | 5 | 5 | 5 | 5 | 5 | 5 |
| FLUX VOLATILITY | | Volatilization time [sec] | 122 | 120 | 158 | 140 | 135 | 185 | 196 | 215 | 219 | 240 | 240 | 140 | 157 | 177 | 154 |
| | | Volatilization amount of flux (%) | 99.9 | 99.8 | 99.1 | 100.0 | 99.9 | 99.8 | 100.00 | 100.17 | 100.0 | 100.0 | 98.8 | 100.13 | 99.97 | 100.07 | 100.0 |
| | | Evaluation ◎ / ○ / × | ◎ | ◎ | ◎ | ◎ | ◎ | ○ | ○ | ○ | ○ | ○ | ○ | ◎ | ◎ | ◎ | ◎ |
| EVALUATION OF SOLDER PASTE A/B/C | | | B | A | A | A | A | A | A | A | C | A | A | A | A | C | B |

[Table 3]

| | | | EX. 28 | EX. 29 | EX. 30 | EX. 31 | EX. 32 | EX. 33 |
|---|---|---|---|---|---|---|---|---|
| CONTENT (MASS%) | FATTY ALCOHOL | 1-Octadecanol | 10 | 10 | 10 | 10 | 10 | 10 |
| | FATTY ACID ESTER | Methyl stearate | 3 | 3 | 3 | 3 | 3 | 3 |
| | LIQUID SOLVENT | 3-methyl 1,5-pentanediol | 40 | 40 | 40 | 40 | 40 | 40 |
| | SOLID SOLVENT | 2,2-dimethyl-1,3-propanediol | 20 | 20 | 20 | 20 | 20 | 20 |
| | | 2,5-dimethyl-2,5-hexanediol | 20 | 20 | 20 | 20 | 20 | 20 |
| | | Trimethylolpropane | 5 | 5 | 5 | 5 | 5 | 5 |
| | THIXOTROPIC AGENT | Lauric acid amide | - | 2 | - | - | - | - |
| | | Palmitate amide | - | - | - | 2 | - | - |
| | | Stearate amide | 2 | - | - | - | - | - |
| | | Behenic acid amide | - | - | - | - | - | 2 |
| | | Oleic acid amide | - | - | 2 | - | - | - |
| | | Erucamide | - | - | - | - | 2 | - |
| FLUX VOLATILITY | | Volatilization time [sec] | 240 | 230 | 215 | 240 | 240 | 240 |
| | | Volatilization amount of flux (%) | 99.6 | 100.0 | 99.7 | 100.0 | 100.0 | 100.0 |
| | | Evaluation ◎ / ○ / × | ○ | ○ | ○ | ○ | ○ | ○ |
| EVALUATION OF SOLDER PASTE A/B/C | | | A | A | A | A | A | A |

[Table 4]

| | | | EX. 34 | EX. 35 | EX. 36 | EX. 37 | EX. 38 | EX. 39 | EX. 40 | EX. 41 | EX. 42 | EX. 43 | EX. 44 |
|---|---|---|---|---|---|---|---|---|---|---|---|---|---|
| CONTENT (MASS%) | FATTY ALCOHOL | 1-Tetradecanol | 13 | - | - | - | - | - | - | 5 | - | - | - |
| | | 1-Hexadecanol | - | 13 | - | - | - | - | - | - | 5 | - | - |
| | | 1-Octadecanol | - | - | 13 | - | - | 10 | 10 | 5 | 5 | 5 | 5 |
| | | 1-Eicosanol | - | - | - | 13 | - | - | - | - | - | 5 | - |
| | | 1-Docosanol | - | - | - | - | 13 | - | - | - | - | - | 5 |
| | FATTY ACID ESTER | Methyl stearate | - | - | - | - | - | - | - | 3 | 3 | 3 | 3 |
| | | Ethyl stearate | - | - | - | - | - | 3 | - | - | - | - | - |
| | | Butyl stearate | - | - | - | - | - | - | 3 | - | - | - | - |
| | LIQUID SOLVENT | 3-methyl 1,5-pentanediol | 40 | 40 | 40 | 40 | 40 | 40 | 40 | 40 | 40 | 40 | 40 |
| | SOLID SOLVENT | 2,2-dimethyl-1,3-propanediol | 20 | 20 | 20 | 20 | 20 | 20 | 20 | 20 | 20 | 20 | 20 |
| | | 2,5-dimethyl-2,5-hexanediol | 20 | 20 | 20 | 20 | 20 | 20 | 20 | 20 | 20 | 20 | 20 |
| | | Trimethylolpropane | 5 | 5 | 5 | 5 | 5 | 5 | 5 | 5 | 5 | 5 | 5 |
| | THIXOTROPIC AGENT | Oleic acid amide | 2 | 2 | 2 | 2 | 2 | 2 | 2 | 2 | 2 | 2 | 2 |
| FLUX VOLATILITY | | Volatilization time [sec] | 146 | 132 | 162 | 186 | 240 | 177 | 240 | 240 | 240 | 225 | 240 |
| | | Volatilization amount of flux (%) | 100.0 | 100.0 | 99.8 | 97.0 | 100.0 | 100.0 | 99.2 | 99.4 | 100.0 | 99.6 | 97.6 |
| | | Evaluation ◎ / ○ / × | ◎ | ◎ | ◎ | ○ | ○ | ◎ | ○ | ○ | ○ | ○ | ○ |
| EVALUATION OF SOLDER PASTE A/B/C | | | B | A | A | A | A | A | A | A | A | A | A |

[Table 5]

| | | | EX. 45 | EX. 46 | EX. 47 | EX. 48 | EX. 49 | EX. 50 | EX. 51 | EX. 52 | EX. 53 | EX. 54 | EX. 55 | EX. 56 | EX. 57 | EX. 58 |
|---|---|---|---|---|---|---|---|---|---|---|---|---|---|---|---|---|
| CONTENT (MASS%) | FATTY ALCOHOL | 1-Hexadecanol | - | - | - | 10 | 20 | 30 | 35 | 40 | - | - | - | - | - | - |
| | | 1-Octadecanol | 1 | 3 | 5 | - | - | - | - | - | - | - | - | - | 10 | 10 |
| | FATTY ACID ESTER | Methyl stearate | - | - | - | - | - | - | - | - | 1 | 3 | 5 | 10 | 20 | 30 |
| | LIQUID SOLVENT | 3-methyl 1,5-pentanediol | 46 | 45 | 44 | 41.5 | 36.5 | 31 | 28.5 | 26.5 | 46 | 45 | 44 | 41.5 | 31.5 | 26.5 |
| | SOLID SOLVENT | 2,2-dimethyl-1,3-propanediol | 23 | 22.5 | 22 | 20.75 | 18.25 | 16 | 14.75 | 13.25 | 23 | 22.5 | 22 | 20.75 | 15.75 | 13.25 |
| | | 2,5-dimethyl-2,5-hexanediol | 23 | 22.5 | 22 | 20.75 | 18.25 | 16 | 14.75 | 13.25 | 23 | 22.5 | 22 | 20.75 | 15.75 | 13.25 |
| | | Trimethylolpropane | 5 | 5 | 5 | 5 | 5 | 5 | 5 | 5 | 5 | 5 | 5 | 5 | 5 | 5 |
| | THIXOTROPIC AGENT | Oleic acid amide | 2 | 2 | 2 | 2 | 2 | 2 | 2 | 2 | 2 | 2 | 2 | 2 | 2 | 2 |
| FLUX VOLATILITY | | Volatilization time [sec] | 165 | 175 | 196 | 134 | 193 | 192 | 214 | 227 | 144 | 150 | 159 | 154 | 155 | 240 |
| | | Volatilization amount of flux (%) | 100.00 | 100.00 | 99.60 | 100.0 | 100.0 | 100.0 | 99.4 | 100.0 | 100.0 | 100.0 | 100.0 | 100.0 | 99.9 | 100.0 |
| | | Evaluation ◎ / ○ / × | ◎ | ◎ | ○ | ◎ | ○ | ○ | ○ | ○ | ◎ | ◎ | ◎ | ◎ | ◎ | ○ |
| EVALUATION OF SOLDER PASTE A/B/C | | | B | B | A | A | A | A | A | A | A | A | A | C | C | C |

## [Table 6]

| CONTENT (MASS%) | | | EX. 59 | EX. 60 | EX. 61 | EX. 62 | EX. 63 | EX. 64 | EX. 65 | EX. 66 |
|---|---|---|---|---|---|---|---|---|---|---|
| | FATTY ALCOHOL | 1-Hexadecanol | 5 | 5 | 5 | 5 | - | - | - | - |
| | | 1-Octadecanol | - | - | - | - | 10 | 10 | 10 | 1 |
| | FATTY ACID ESTER | Methyl stearate | - | - | - | - | 3 | 3 | 3 | 1 |
| | LIQUID SOLVENT | 3-methyl 1,5-pentanediol | 42.5 | 40 | 37.5 | 35 | 40 | 40 | 40 | 36.5 |
| | SOLID SOLVENT | 2,2-dimethyl-1,3-propanediol | 21.25 | 20 | 18.75 | 17.5 | 20 | 20 | 20 | 18.25 |
| | | 2,5-dimethyl-2,5-hexanediol | 21.25 | 20 | 18.75 | 17.5 | 20 | 20 | 20 | 18.25 |
| | | Trimethylolpropane | 5 | 5 | 5 | 5 | 5 | 5 | 5 | 5 |
| | THIXOTROPIC AGENT | Stearate amide | - | - | - | - | - | - | 1 | 10 |
| | | Lauric acid amide | - | - | - | - | - | - | 1 | 10 |
| | | Palmitate amide | - | - | - | - | 1 | - | - | - |
| | | Oleic acid amide | 5 | 10 | 15 | 20 | 1 | - | - | - |
| | | Erucamide | - | - | - | - | - | 1 | - | - |
| | | Behenic acid amide | - | - | - | - | - | 1 | - | - |
| FLUX VOLATILITY | | Volatilization time [sec] | 196 | 240 | 240 | 240 | 195 | 210 | 240 | 230 |
| | | Volatilization amount of flux (%) | 99.8 | 97.8 | 99.8 | 97.4 | 99.1 | 98.3 | 99.7 | 98.7 |
| | | Evaluation ◎/○/× | ○ | ○ | ○ | ○ | ○ | ○ | ○ | ○ |
| EVALUATION OF SOLDER PASTE A/B/C | | | A | A | A | A | A | A | A | C |

## [Table 7]

| CONTENT (MASS%) | | | EX. 67 | EX. 68 | EX. 69 | EX. 70 | EX. 71 | EX. 72 | EX. 73 | EX. 74 | EX. 75 | EX. 76 | EX. 77 |
|---|---|---|---|---|---|---|---|---|---|---|---|---|---|
| | FATTY ALCOHOL | 1-Octadecanol | 10 | 10 | 10 | 10 | 10 | 10 | 10 | 10 | 10 | 10 | 10 |
| | FATTY ACID ESTER | Methyl stearate | 3 | 3 | 3 | 3 | 3 | 3 | 3 | 3 | 3 | 3 | 3 |
| | LIQUID SOLVENT (with two hydroxy groups) | 3-methyl 1,5-pentanediol | - | - | - | - | 35 | 35 | 35 | 35 | 35 | 35 | 35 |
| | | 1,4-butanediol | 40 | - | - | - | - | - | - | - | - | - | - |
| | | 2,5-hexanediol | - | 40 | - | - | - | - | - | - | - | - | - |
| | | 1,5-pentanediol | - | - | 40 | - | - | - | - | - | - | - | - |
| | | 2,4-diethyl-1,5-pentanediol | - | - | - | 40 | - | - | - | - | - | - | - |
| | LIQUID SOLVENT (with three or more hydroxy groups) | 1,2,6-hexanetriol | - | - | - | - | 5 | - | - | - | - | - | - |
| | | 1,2,4-butanetriol | - | - | - | - | - | 5 | - | - | - | - | - |
| | LIQUID SOLVENT (with one hydroxy group) | Hexyldecanol | - | - | - | - | - | - | 5 | - | - | - | - |
| | | Isostearyl alcohol | - | - | - | - | - | - | - | 5 | - | - | - |
| | | 2-Octyldodecanol | - | - | - | - | - | - | - | - | 5 | - | - |
| | | 2-Decyltetradecanol | - | - | - | - | - | - | - | - | - | 5 | - |
| | | Oleyl alcohol | - | - | - | - | - | - | - | - | - | - | 5 |
| | SOLID SOLVENT | 2,2-dimethyl-1,3-propanediol | 20 | 20 | 20 | 20 | 20 | 20 | 20 | 20 | 20 | 20 | 20 |
| | | 2,5-dimethyl-2,5-hexanediol | 20 | 20 | 20 | 20 | 20 | 20 | 20 | 20 | 20 | 20 | 20 |
| | | Trimethylolpropane | 5 | 5 | 5 | 5 | 5 | 5 | 5 | 5 | 5 | 5 | 5 |
| | THIXOTROPIC AGENT | Oleic acid amide | 2 | 2 | 2 | 2 | 2 | 2 | 2 | 2 | 2 | 2 | 2 |
| FLUX VOLATILITY | | Volatilization time [sec] | 205 | 173 | 150 | 180 | 225 | 165 | 165 | 155 | 240 | 190 | 193 |
| | | Volatilization amount of flux (%) | 98.7 | 98.0 | 99.9 | 100.0 | 99.1 | 97.0 | 97.2 | 100.0 | 98.3 | 99.9 | 99.6 |
| | | Evaluation ◎/○/× | ○ | ◎ | ◎ | ◎ | ○ | ◎ | ◎ | ◎ | ○ | ○ | ○ |
| EVALUATION OF SOLDER PASTE A/B/C | | | A | A | A | A | A | A | A | A | A | A | A |

[Table 8]

| | | | EX. 78 | EX. 79 | EX. 80 | EX. 81 | EX. 82 | EX. 83 | EX. 84 |
|---|---|---|---|---|---|---|---|---|---|
| CONTENT (MASS%) | FATTY ALCOHOL | 1-Octadecanol | 10 | 10 | 10 | 10 | 10 | 10 | 1 |
| | FATTY ACID ESTER | Methyl stearate | 3 | 3 | 3 | 3 | 3 | 3 | - |
| | LIQUID SOLVENT | 3-methyl 1,5-pentanediol | 5 | 10 | 15 | 20 | 60 | 80 | 5 |
| | SOLID SOLVENT | 2,2-dimethyl-1,3-propanediol | 37.5 | 35 | 32.5 | 30 | 10 | - | 43.5 |
| | | 2,5-dimethyl-2,5-hexanediol | 37.5 | 35 | 32.5 | 30 | 10 | - | 43.5 |
| | | Trimethylolpropane | 5 | 5 | 5 | 5 | 5 | 5 | 5 |
| | THIXOTROPIC AGENT | Oleic acid amide | 2 | 2 | 2 | 2 | 2 | 2 | 2 |
| FLUX VOLATILITY | | Volatilization time [sec] | 240 | 240 | 240 | 240 | 225 | 225 | 150 |
| | | Volatilization amount of flux (%) | 100.0 | 100.0 | 99.6 | 100.0 | 100.0 | 99.7 | 99.3 |
| | | Evaluation ◎/○/× | ○ | ○ | ○ | ○ | ○ | ○ | ◎ |
| EVALUATION OF SOLDER PASTE A/B/C | | | A | A | A | A | A | B | A |

[Table 9]

| | | | EX. 85 | EX. 86 | EX. 87 | EX. 88 | EX. 89 | EX. 90 | EX. 91 | EX. 92 | EX. 03 | EX. 94 |
|---|---|---|---|---|---|---|---|---|---|---|---|---|
| CONTENT (MASS%) | FATTY ALCOHOL | 1-Hexadecanol | 10 | 10 | 10 | 10 | 10 | 10 | 10 | 10 | 10 | 10 |
| | FATTY ACID ESTER | Methyl stearate | 3 | 3 | 3 | 3 | 3 | 3 | 3 | 3 | 3 | 3 |
| | LIQUID SOLVENT | 3-methyl 1,5-pentanediol | 40 | 40 | 40 | 40 | 40 | 40 | 40 | 40 | 40 | 40 |
| | SOID SOLVENT | 2,2-dimethyl-1,3-propanediol | - | - | - | - | 20 | 20 | 10 | 30 | 10 | - |
| | | 2,5-dimethyl-2,5-hexanediol | - | - | - | - | 20 | 20 | 30 | 10 | 10 | - |
| | | 2,2,4-trimethyl-1,3-pentanediol | 20 | - | - | - | - | - | - | - | - | - |
| | | 2-butyl-2-ethyl-1,3-propanediol | 20 | - | - | - | - | - | - | - | - | - |
| | | 1,2-octanediol | - | 20 | - | - | - | - | - | - | - | - |
| | | 1,8-octanediol | - | 20 | - | - | - | - | - | - | - | - |
| | | 1,10-decanediol | - | - | 20 | - | - | - | - | - | - | - |
| | | 1,2-dodecanediol | - | - | 20 | - | - | - | - | - | - | - |
| | | 1,6-hexanediol | - | - | - | 20 | - | - | - | - | - | - |
| | | 1,9-nonanediol | - | - | - | 20 | - | - | - | - | - | - |
| | SOLID SOLVENT (with three or more hydroxy groups) | Trimethylolethane | - | - | - | - | 5 | - | - | - | - | - |
| | | Trimethylolpropane | 5 | 5 | 5 | 5 | - | - | 5 | 5 | 25 | 45 |
| | | Erythritol | - | - | - | - | - | 5 | - | - | - | - |
| | THIXOTROPIC AGENT | Oleic acid amide | 2 | 2 | 2 | 2 | 2 | 2 | 2 | 2 | 2 | 2 |
| FLUX VOLATILITY | | Volatilization time [sec] | 145 | 240 | 190 | 185 | 185 | 155 | 140 | 160 | 213 | 175 |
| | | Volatilization amount of flux (%) | 99.9 | 99.4 | 99.2 | 99.6 | 99.7 | 100.0 | 100.0 | 98.8 | 99.5 | 99.2 |
| | | Evaluation ◎/○/× | ◎ | ○ | ○ | ○ | ○ | ◎ | ◎ | ◎ | ○ | ◎ |
| EVALUATION OF SOLDER PASTE A/B/C | | | A | A | A | A | A | A | A | A | A | A |

[Table 10]

| | | | COMP. EX. 1 |
|---|---|---|---|
| CONTENT (MASS%) | FATTY ALCOHOL | 1-Hexadecanol | 5 |
| | LIQUID SOLVENT | 3-methyl 1,5-pentanediol | 32.5 |
| | SOLID SOLVENT | 2,2-dimethyl-1,3-propanediol | 16.25 |
| | | 2,5-dimethyl-2,5-hexanediol | 16.25 |
| | | Trimethylolpropane | 5 |
| | THIXOTROPIC AGENT | Oleyl alcohol | 25 |
| FLUX VOLATILITY | | Volatilization time [sec] | 240 |
| | | Volatilization amount of flux (%) | 96.9 |
| | | Evaluation ◎/○/× | × |
| EVALUATION OF SOLDER PASTE A/B/C | | | A |

<Evaluation for Flux Volatility>

First, the weight of the evaporation dish was measured, and the weight was set as W1. Next, 0.3 to 0.303 g of the flux of each example and each comparative example was measured out into the evaporation dish, and the weight was set as W2. Subsequently, the evaporation dish into which the flux was measured out was placed on a hot plate heated to 350°C, and the time until the entire flux was volatilized was measured visually, and then the evaporation dish was removed from the hot plate and cooled to room temperature. Regardless of whether the flux was not entirely volatilized even after the elapse of a maximum heating time which was set to 240 seconds, the evaporation dish was removed from the hot plate and cooled to room temperature. The weight of the evaporation dish cooled to room temperature was measured, and the weight was set as W3. From the following equation (1), the flux volatilization amount [%] of each example and each comparative example was calculated. The results are shown in Tables 1 to 10.
Volatilization amount of flux

$$[\%] = (W2-(W3-W1))/W2 \times 100 \qquad (1)$$

In the equation, W1 is the weight of the evaporation dish, W2 is the weight of the evaporation dish into which the flux was measured out, and W3 is the weight of the evaporation dish when the evaporation dish into which the flux was measured out was heated and cooled to room temperature.
Flux volatility was evaluated based on the following criteria. The results are shown in Tables 1 to 10.

◎: The volatilization amount of the flux [%] is 97% or more, and the time until the flux volatilizes is within 180 seconds.
O: The volatilization amount of the flux [%] is 97% or more, and the time until the flux volatilizes is within 240 seconds.
×: The volatilization amount of the flux [%] is 97% or less.

<Evaluation of Solder Paste>

The solder paste of each example and each comparative example was left for 1 hour in an environment at 20 to 30°C, and then the state of the solder paste was confirmed. The evaluation of the solder paste was performed based on the following criteria. The results are shown in Tables 1 to 10. "Separation of flux" means a state in which the solder alloy powder in the solder alloy paste settles and flux accumulates on the top of the settled solder alloy paste due to the specific gravity difference between the solder alloy powder and the flux.

A: No change (flux and solder alloy powder dispersed)
B: There is a separation of the flux, and the solder paste returns to the state A by stirring with the spatula.

C: The solder paste is hard, but it returns to the state A by stirring with the spatula.

As can be seen from the results of Tables 1 to 10, the flux of each example that satisfies all the requirements of the present invention has a volatilization amount of flux being 97% or more and a time until the flux volatilizes being within 240 seconds. Therefore, the flux according to the present invention can shorten the reflow process time to achieve low residue.

## Claims

1.  A flux used for soldering,

    the flux comprising: at least one selected from the group consisting of a fatty alcohol having one hydroxy group and being solid at 20°C and a fatty acid ester being solid at 20°C;
    a liquid solvent having one or more and three or less hydroxy groups and being liquid at 20°C; and
    a solid solvent having two or more and four or less hydroxy groups and being solid at 20°C,
    the flux comprising no thixotropic agent or comprising 20.0 mass% or less of a thixotropic agent based on the entire flux.

2.  The flux according to claim 1, wherein

    the flux comprises the fatty alcohol, and
    the content of the fatty alcohol is 0.5 mass% or more and 45.0 mass% or less based on the entire flux.

3.  The flux according to claim 1, wherein

    the flux comprises the fatty acid ester, and
    the content of the fatty acid ester is 0.5 mass% or more and 45.0 mass% or less based on the entire flux.

4.  The flux according to claim 1, wherein
    the fatty alcohol is at least one selected from the group consisting of 1-dodecanol, 1-tetradecanol, 1-hexadecanol, 1-octadecanol, 1-eicosanol, and 1-docosanol.

5.  The flux according to claim 1, wherein
    the fatty acid ester is at least one selected from the group consisting of methyl stearate, ethyl stearate, and butyl stearate.

6.  A solder paste comprising the flux according to claim 1, and a solder alloy powder.

7.  A method for producing a joined structure in which a substrate and a joining part are joined together using the solder paste according to claim 6.

## INTERNATIONAL SEARCH REPORT

International application No.

**PCT/JP2023/029244**

| A. | CLASSIFICATION OF SUBJECT MATTER |
|---|---|

**B23K 35/363**(2006.01)i
FI: B23K35/363 D

According to International Patent Classification (IPC) or to both national classification and IPC

| B. | FIELDS SEARCHED |
|---|---|

Minimum documentation searched (classification system followed by classification symbols)

B23K35/363

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| Y | JP 2022-129960 A (KOKI KK) 06 September 2022 (2022-09-06) paragraphs [0064]-[0083], example 69 | 1-2, 4-7 |
| A | | 3 |
| Y | JP 04-262893 A (ASAHI CHEM RES LAB LTD.) 18 September 1992 (1992-09-18) paragraphs [0002]-[0012] | 1-2, 4-7 |
| A | WO 2019/172410 A1 (ORIGIN CO., LTD.) 12 September 2019 (2019-09-12) | 1-7 |
| A | JP 2019-147185 A (SENJU METAL INDUSTRY CO., LTD.) 05 September 2019 (2019-09-05) | 1-7 |
| A | JP 2021-090999 A (SENJU METAL INDUSTRY CO., LTD.) 17 June 2021 (2021-06-17) | 1-7 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 October 2023** | **31 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/029244**

| Patent document cited in search report | | | Publication date (day/month/year) | Patent family member(s) | Publication date (day/month/year) |
|---|---|---|---|---|---|
| JP | 2022-129960 | A | 06 September 2022 | (Family: none) | |
| JP | 04-262893 | A | 18 September 1992 | (Family: none) | |
| WO | 2019/172410 | A1 | 12 September 2019 | US 2020/0398383 A1 | |
| | | | | EP 3763477 A1 | |
| | | | | CN 111836695 A | |
| | | | | KR 10-2020-0125651 A | |
| JP | 2019-147185 | A | 05 September 2019 | (Family: none) | |
| JP | 2021-090999 | A | 17 June 2021 | (Family: none) | |

Form PCT/ISA/210 (patent family annex) (January 2015)

**EP 4 530 009 A1**

**Patent documents cited in the description**

- JP 2019038026 A